(19) Europäisches Patentamt
European Patent Office
Office européen des brevets

(11) **EP 4 749 135 A1**

(12) **EUROPEAN PATENT APPLICATION**

(43) Date of publication:
**27.05.2026 Bulletin 2026/22**

(21) Application number: **25157758.1**

(22) Date of filing: **13.02.2025**

(51) International Patent Classification (IPC):
**F04D 15/00** (2006.01)   **G06F 1/20** (2006.01)
**H05K 7/20** (2006.01)

(52) Cooperative Patent Classification (CPC):
**F04D 15/0016; F04D 15/0066; F04D 15/0072;
G06F 1/206; H05K 7/20781; H05K 7/20836;**
G06F 2200/201

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **20.11.2024 CN 202411661350**

(71) Applicant: **DELTA ELECTRONICS, INC.
Taoyuan City 320023 (TW)**

(72) Inventors:
• **FANG, Zihyang
320023 Taoyuan City (TW)**

• **HO, Hong-Yi
320023 Taoyuan City (TW)**
• **CHANG, Ren-Chun
320023 Taoyuan City (TW)**
• **CHENG, Chun-Hung
320023 Taoyuan City (TW)**
• **YANG, Sheng-Hong
320023 Taoyuan City (TW)**

(74) Representative: **2K Patent Partnerschaft mbB
Hamburger Allee 26-28
60486 Frankfurt am Main (DE)**

Remarks:
Amended claims in accordance with Rule 137(2) EPC.

(54) **CONTROL SYSTEM FOR COOLING DISTRIBUTION UNIT AND CONTROL METHOD FOR CDU GROUP FLOW CONTROL**

(57)    A control method for cooling distribution units (CDUs) is disclosed. The control method is applied to a CDU control system having a group at least including a first CDU (81) and a second CDU (82), and includes the following steps: detecting the second CDU (82) of a resting state; sending a low rotation-speed command to the first CDU (81) and the second CDU (82) to indicate both of the first and second CDUs (81, 82) to operate at a second rotation speed, wherein the second rotation speed is slower than a first rotation speed at which the first CDU (81) currently operated; and, when determining both of the first and second CDUs (81, 82) to be operating at the second rotation speed for a preset time length, sending a target flow command to the first CDU (81) and the second CDU (82) to indicate both of the first and second CDUs (81, 82) to operate and output a target flow of cooling liquid.

EP 4 749 135 A1

FIG.5

**Description**

**BACKGROUND OF THE DISCLOSURE**

Technical Field

The disclosure generally relates to cooling distribution units, particularly to a control system for cooling distribution units and a control method for cooling distribution units.

Description of Related Art

To reduce temperature or perform heat dissipation for server racks, cooling distribution units (CDUs) are arranged in data centers to perform heat dissipation for the server racks by delivering the cooling liquid from and back to CDUs.

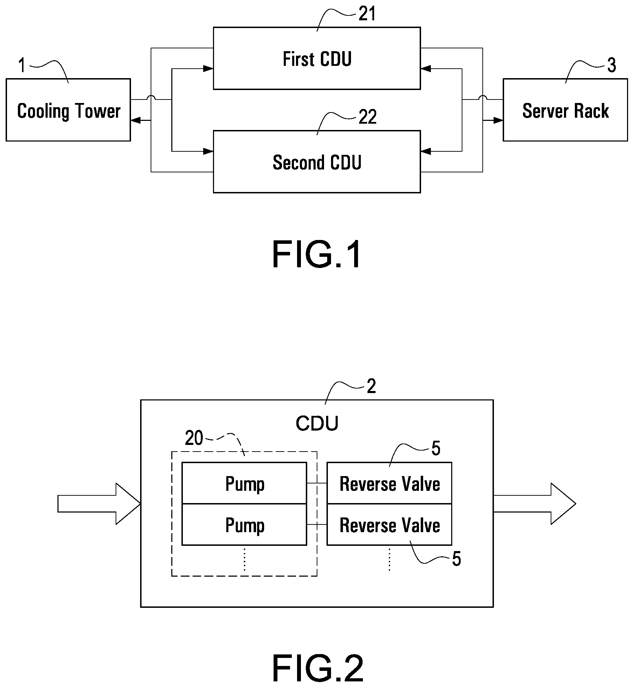

Fig. 1 is an exemplary illustration of a cooling system. Fig. 1 illustrates the cooling system having a cooling tower, and the cooling tower 1 is constructed by two CDUs (including a first CDU 21 and a second CDU 22). The cooling system is connected to a server rack 3 by the first CDU 21 and the second CDU 22 to perform heat dissipation for the server rack 3. Arranging multiple first CDUs 21 and multiple second CDUs 22 in the cooling system may equally distribute the demand of the liquid flow for each cooling system. Furthermore, when one CDU loses its function, other CDUs may become the backup CDU by increasing their output flows.

Fig. 2 is a schematic diagram of delivering the cooling liquid. As shown in Fig. 2, each CDU 2 includes a pump group 20 having multiple pumps and a reverse valve 5 disposed behind each pump. Each CDU 2 performs a PID control to its pump group 20 when performing functional operations, so the output liquid of the CDU 2 is maintained at the target flow specified by the cooling system. When one of the multiple CDUs 2 malfunctions, the cooling system will increase the pump rotation speed of the pump group 20 of the remained normal CDUs 2, so the target flow of cooling liquid outputted by the CDU 2 in operation may compensate for the nominal flow of the malfunctioning CDU 2. Therefore, the overall heat-dissipating capability of the cooling system will not be affected by the malfunctioning CDU 2.

Generally, when the cooling system includes multiple CDUs 2, the multiple CDUs are disposed in parallel, and each CDU 2 controls the rotation speed of one or more pumps by a CDU control unit of the CDU 2 to control the flow of the cooling liquid, and the reverse valve 5 of the CDU 2 can prevent the cooling liquid from flowing back. When a new CDU is added to the cooling system or one CDU is recovered from the malfunctioning status (hereinafter referred to as a "new CDU"), the new CDU has to work from a resting state. At this time, the pressure generated by the normal CDUs 2 will depress the reverse valve 5 of the new CDU, such that the new CDU cannot increase its liquid flow. In this case, the cooling system has to make the new CDU operate at full rotation speed, such that the new CDU can deliver the liquid flow against the outside pressure from the reverse valve 5.

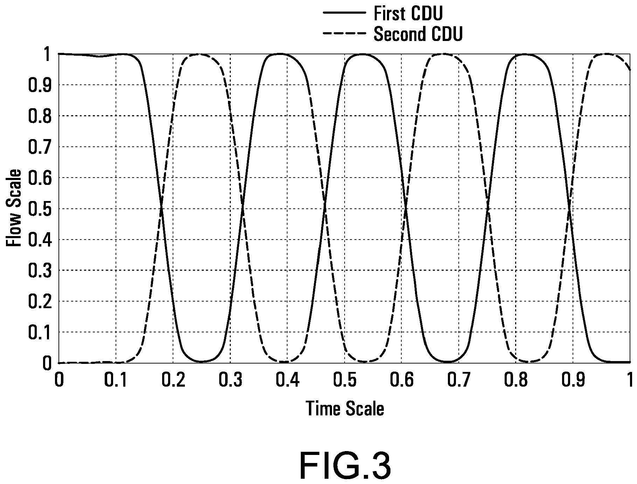

However, as shown in Fig. 3, when the new CDU (such as the second CDU in Fig. 3) operates at full rotation speed (such as the output of the flow scale immediately increasing to 1), the liquid flow of other CDUs (such as the first CDU in Fig. 3) will be depressed and then immediately decreases (such as the output of the flow scale immediately decrease to 0). At this time, the cooling system has to make the first CDU operate at full rotation speed to increase the output flow of the first CDU (such as the output of the flow scale immediately increasing to 1). After repeating the control operation to the first CDU and the second CDU by the cooling system, the rotation speeds of the pump group 20 of the CDUs (such as the first CDU and the second CDU in Fig. 3) fluctuate up and down, making the cooling system unstable, and more poorly, leading to damage of the CDUs.

Accordingly, how to control the cooling system to provide a cooling system while adding new CDUs fast and stably and maintaining the stability of the cooling system is a subject of dedicated research for the skilled in the art.

**SUMMARY OF THE DISCLOSURE**

The subject of the disclosure is to provide a control system for cooling distribution units (CDUs) and a control method for a CDU group flow control to stably add a new CDU to an existing CDU group, so all the CDUs may stably operate.

In one embodiment, the control system for CDUs of the disclosure includes:

a first CDU configured to operate at a first rotation speed; and
a second CDU configured to be a resting state, where a group comprises the first CDU and the second CDU;
where any CDU of the group is configured to send a low rotation-speed command to the first CDU and the second CDU to indicate the first CDU and the second CDU to operate at a second rotation speed, where the second rotation speed is slower than the first rotation speed;
where the any CDU of the group is configured to send a target flow command to the first CDU and the second CDU when both the first CDU and the second CDU operate at the second rotation speed for a preset time length, to respectively indicate the first CDU and the second CDU to output a target flow.

In one embodiment, the control method for cooling distribution units (CDUs) is applied to the CDU control system above and includes the following steps:

detecting that the second CDU is activated from a resting state;

sending a low rotation-speed command to the first CDU and the second CDU by any CDU of the group to indicate the first CDU and the second CDU to operate at a second rotation speed, where the second rotation speed is lower than the first rotation speed; and

when determining that both the first CDU and the second CDU operate at the second rotation speed for a preset time length, sending a target flow command to the first CDU and the second CDU by any CDU of the group to indicate the first CDU and the second CDU to respectively output a target flow.

Compared with the related art, the technical features of the disclosure make all the CDUs operate at a low rotation speed and then control all the CDUs to recover the target flow after the output flows of all the CDUs are stable. Therefore, the problem of operational instability induced by the CDU group when the new CDU is joined to the group is resolved.

**BRIEF DESCRIPTION OF THE DRAWINGS**

Fig. 1 is an exemplary illustration of a cooling system.
Fig. 2 is a schematic diagram of outputting the cooling liquid.
Fig. 3 is a waveform diagram of a flow control for the cooling distribution unit.
Fig. 4 is a schematic diagram of a system for the cooling distribution unit of an embodiment of the disclosure.
Fig. 5 is an embodiment of a flowchart of the control method of the disclosure.
Fig. 6 is a waveform diagram of a flow control for the cooling distribution unit of the disclosure.
Fig. 7 is another embodiment of a flowchart of the control method of the disclosure.

**DETAILED DESCRIPTION**

The disclosure provides a control system for a cooling distribution unit (CDU) and a control method thereof, controlling a CDU group including multiple CDUs to make the multiple CDUs of the CDU group stably operate and make the total output flow of the multiple CDUs satisfy the requirement of the heat dissipation.

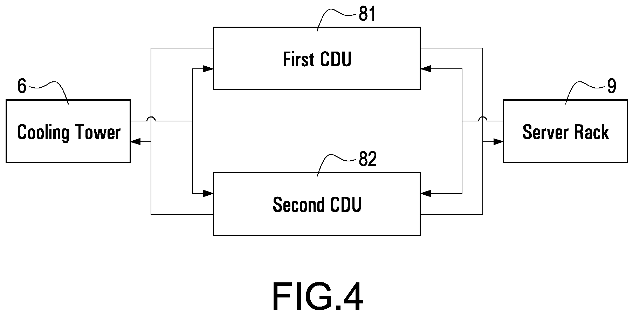

Fig. 4 is a schematic diagram of a system for the cooling distribution unit of an embodiment of the disclosure. As shown in Fig. 4, the control system of the disclosure has a group including multiple CDUs, the group at least includes a first CDU 81 and a second CDU 82, and each CDU 81 and 82 connects through a non-Master/-Slave communication with each other. Therefore, each of the CDUs 81 and 82 of the group may communicate through the communication lines with each other by a control unit (not shown in figures) in each CDU, so the output flows of the first CDU 81 and the second CDU 82 are controlled.

Specifically, one side of the first CDU 81 and the second CDU 82 respectively connects to a cooling tower 6, and another side of the first CDU 81 and the second CDU 82 respectively connects to a server rack 9. The first CDU 81 and the second CDU 82 respectively have a pump group (such as the pump group 20 of Fig. 2). The pump group operates based on a default duty cycle, such that the first CDU 81 and the second CDU 82 receive the cooling liquid flowing from the cooling tower 6 and output the cooling liquid with some specific flow to the server rack 9 to perform the heat dissipation, and then deliver the cooling liquid absorbing the heats back to the cooling tower 6 to cool down the liquid, which demonstrates an example of a heat dissipation cycle. In one embodiment, any CDU of the group may send a rotation-speed command to the first CDU 81 and the second CDU 82 to control the rotation speed of the pump group of the first CDU 81 and the second CDU 82, so the flow of the cooling liquid delivered to the server rack 9 from the first CDU 81 and the second CDU 82 may be adjusted. In another embodiment, any CDU of the group may send a flow command to the first CDU 81 and the second CDU 82 to make the first CDU 81 and the second CDU 82 automatically adjust the rotation speed of the pump group, so the flow of the cooling liquid delivered to the server rack 9 satisfies the indication of the flow command.

As described above, any CDU of the group may be the command generator and the sender to control other CDUs. Specifically, the CDU generates the command by the CDU control unit of the CDU, and the CDU communicates with other CDUs through the communication lines and sends the command to other CDUs. In one embodiment, the CDU control unit may be, but not limited to, a Central Processing Unit (CPU), a Micro Control Unit (MCU), a Programmable Logic Controller (PLC), a System on Chip (SoC), or a Field Programmable Gate Array (FPGA).

In the embodiment of Fig. 4, taking two CDUs as one example (i.e., the first CDU 81 and the second CDU 82); however, the control system of the disclosure may include multiple CDUs other than 2 CDUs, and the quantity of the CDUs is not limited to the scenario shown in Fig. 4. Specifically, the technical feature of the disclosure is that one of the multiple CDUs of the control system starts to work from a resting state, the CDU control unit of any one of the CDUs performs a synchronization control to all the CDUs, so the multiple CDUs may operate stably, and all the CDUs respectively output the cooling liquid with the target flow finally.

For example, when the control system operates in a stable state, the first CDU 81 operates at a first rotation speed (i.e., the pump group of the first CDU 81 works at the first rotation speed) and outputs a first flow of the cooling liquid, and the second CDU 82 also operates at the first rotation speed (i.e., the pump group of the second CDU 82 works at the first rotation speed) and outputs the first flow of the cooling liquid. Furthermore, the total output flow of the first CDU 81 and the second CDU 82 (i.e., twice the first flow) is equal to or extremely close to the demand flow set by a user. It should be noted that the demand flow may be set based on the scale of the data center, the size of the server rack 9, the efficiency of the first CDU 81 and the second CDU 82, the property of the cooling liquid, and the length or size of the pipe, to satisfy with the flow for the heat dissipation of the server rack 9.

When the second CDU 82 fails, any one of the CDUs of the group (i.e., any one of the remaining CDUs except the failed CDU in the group) controls the second CDU 82 to stop operating. At this time, the first CDU 81 has to compensate for the flow of the second CDU 82, so the first CDU 81 plays the role of the backup CDU of the second CDU 82. Therefore, the CDU control unit of the first CDU 81 sends a command to increase the rotation speed of the first CDU 81, such that the first CDU 81 works at a rotation speed greater than the first rotation speed to make the first CDU 81 output the flow satisfying the demand flow.

When the second CDU 82 recovers from the malfunction state or a new CDU is joined to the control system as a new second CDU replacing the old second CDU, the CDU control unit of the CDU detects that the second CDU 82 works from the resting state. At this time, because the rotation speed of the first CDU 81 is high and the rotation speed of the second CDU 82 is low (related to the required speed), the reverse valve (e.g., the reverse valve 5 of Fig. 2) of the second CDU 82 may be depressed by the pressure of the first CDU 81, such that the cooling liquid outputted by the second CDU 82 may not pass through the reverse valve. To solve the problem, when the CDU control unit of any CDU of the group detects that the second CDU 82 works from the resting state, the CDU control unit controls the first CDU 81 and the second CDU 82 to work at a second rotation speed lower than the first rotation speed at the same time. By decreasing the rotation speed that the first CDU 81 currently works and increasing the rotation speed that the second CDU 82 initially works, the second CDU 82 may break through the pressure forced on the reverse valve, so the cooling liquid outputted by the second CDU 82 may pass through the reverse valve and the second CDU may stably deliver the cooling liquid with the flow corresponding to the second rotation speed.

As stated above, because the CDU control unit of any CDU of the group makes the first CDU 81 and the second CDU 82 work at the same second rotation speed, after the first CDU 81 and the second CDU 82 work at a stable state, the first CDU 81 and the second CDU 82 output the cooling liquid of the same or similar flow. However, to make the second CDU 82 working at the low rotation speed break through the pressure provided by the first CDU 81 working at the high rotation speed, the CDU control unit of any CDU of the group makes the first CDU 81 and the second CDU 82 work at relatively low rotation speed section, so the total output flow is lower than the demand flow of the control system. After both the first CDU 81 and the second CDU 82 work stably at the second rotation speed, the CDU control unit sends the command again to the first CDU 81 and the second CDU 82 to increase the output flow of the first CDU 81 and the second CDU 82, so the first CDU 81 and the second CDU 82 respectively output the target flow and the total of the target flow of the first CDU 81 and the second CDU 82 is equal to or extremely close to the demand flow of the control system. That is,

$$the\ target\ flow = \frac{the\ demand\ flow}{the\ quantity\ of\ the\ CDUs}.$$

Controlling all the CDUs to work at the stable state first and then controlling each CDU to increase the output flow to the target flow solves the problem that the reverse valve of one CDU is depressed by the pressure caused by other CDUs and all the CDUs work at an unstable state because the rotation speed of all the CDUs is enforced to frequently switch between the high and low rotation speed.

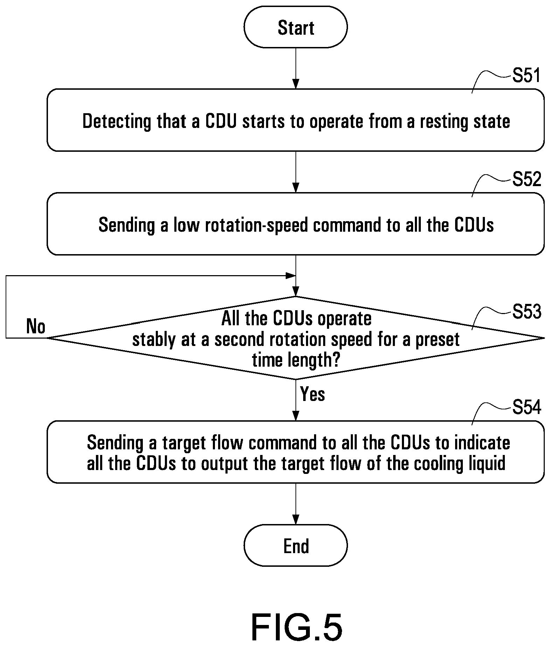

Fig. 5 is an embodiment of a flowchart of the control method of the disclosure. Fig. 5 illustrates the steps of the control method of the disclosure, and the control method is applied to the control system shown in Fig. 4. Specifically, the control system includes multiple CDUs and each CDU has the CDU control unit. In one embodiment, each CDU control unit stores firmware consisting of multiple computer executable codes, and when the CDU control unit executes the firmware, the CDU control unit may control the CDU group including the multiple CDUs by the steps of Fig. 5 to implement the control method of the disclosure. In other words, the CDU control unit of each CDU may play the role of the main control unit in the entire control system.

As shown in Fig. 5, during the time of one or more CDUs of the control system continuously working, the CDU control unit of any CDU of the group is set to continuously detect one or more CDUs and determine whether any CDU starts to operate from the resting state (step S51). When detecting the CDU starting to operate from the resting state, the CDU control unit of the CDU generates a low rotation-speed command and synchronously sends the low rotation-speed command to all the CDUs of the control system by the communication lines (step S52). For the sake of understanding the disclosure, the following example and statement incorporates the control system shown in Fig. 4, any CDU of the group detects the second CDU 82 to start to operate from the resting state and sends the low rotation-speed command to the first CDU 81 working at the first rotation speed and the second CDU 82 currently at the resting state at the same time.

In one embodiment, the second CDU 82 at the resting state indicates that it is a new CDU joined to the CDU group of the control system, and the new CDU starts to operate from the resting state. In another embodiment, the second CDU 82 at the resting state indicates that it is an existing CDU of the CDU group of the control system while it fails to operate correctly and stops working, and further, the CDU recovers from the malfunction state to start to operate from the resting state. In another embodiment, the second CDU 82 at the resting state indicates the backup CDU existing in the CDU group of the control system without working and when one of the CDUs of the CDU group fails, the backup CDU starts to operate from the resting state to replace the malfunctioned CDU. However, the statement above is provided as a part of the embodiment of the disclosure, it is not limited thereto.

In the disclosure, the CDU control unit of any CDU of the group sends the low rotation-speed command to both the first CDU 81 at the first rotation speed and the second CDU 82 at the resting state, to indicate the first CDU 81 and the second CDU 82 to operate at the second rotation speed, where the second rotation speed is lower than the first rotation speed that the first CDU 81 currently operates.

Specifically, the pump of the first CDU 81 connects to a reverse valve (such as the first reverse valve) behind the pump, the pump of the second CDU 82 also connects to a reverse valve (such as the second reverse valve) behind the pump, and the first CDU 81 and the second CDU 82 are disposed in parallel. As described above, because the first CDU 81 works at a high rotation speed generating high pressure, the outward force of the flow of the second CDU 82 while starting to operate from the resting state is smaller than the force resisted by the second reverse valve from the first CDU 81, such that the cooling liquid outputted by the second CDU 82 cannot pass through the second reverse valve. Therefore, in the control method of the disclosure, the CDU control unit of any CDU of the group sends the low rotation-speed command to control the first CDU 81 and the second CDU 82 to operate at the second rotation speed, to decrease the current rotation speed of the first CDU 81 and increase the initial rotation speed of the second CDU 82. Hence the output force of the second CDU 82 breaks through the force resisted by the second reverse valve behind the pump, so the cooling liquid outputted by the second CDU 82 is capable of passing through the second reverse valve, and the cooling liquid, delivered by the second CDU 82, will correspond to the second rotation speed. In other words, the second rotation speed indicates a rotation speed that enables the cooling liquid outputted by the first CDU 81 pass through the first reverse valve and enables the cooling liquid outputted by the second CDU 82 pass through the second reverse valve without being blocked by the pressure caused by the first CDU 81. The low rotation-speed command indicates the control command of controlling the first CDU 81 and the second CDU 82 to operate at the second rotation speed.

In one embodiment, the first CDU 81 has a first pump group, and the second CDU 82 has a second pump group. The first pump group and the second pump group operate with a default work cycle preset by the control system, to make the first CDU 81 and the second CDU 82 stably output the target flow of the cooling liquid indicated by the control system. In one embodiment, the work cycle corresponds to a rated frequency of the first pump group and the second pump group, and the second rotation speed is about 50% to 70% of the work cycle of the first pump group and the second pump group. When the first CDU 81 and the second CDU 82 stably operate at the second rotation speed, the output flow of the first CDU 81 and the second CDU 82 is about 80% of the target flow, whereas it is not limited thereto.

Referring to Fig. 5, after step S52, the first CDU 81 and the second CDU 82 operate based on the low rotation-speed command, and the CDU control unit of any CDU of the group is set to continuously detect the first CDU 81 and the second CDU 82 to determine whether the first CDU 81 and the second CDU 82 operate stably at the second rotation speed for a preset time length (step S53). When the CDU control unit detects that both the first CDU 81 and the second CDU 82 operate stably at the second rotation speed for the preset time length, the CDU control unit generates a target flow command and sends the target flow command to the first CDU 81 and the second CDU 82 to respectively indicate the first CDU 81 and the second CDU 82 to increase the rotation speed to output the target flow of the cooling liquid (step S54).

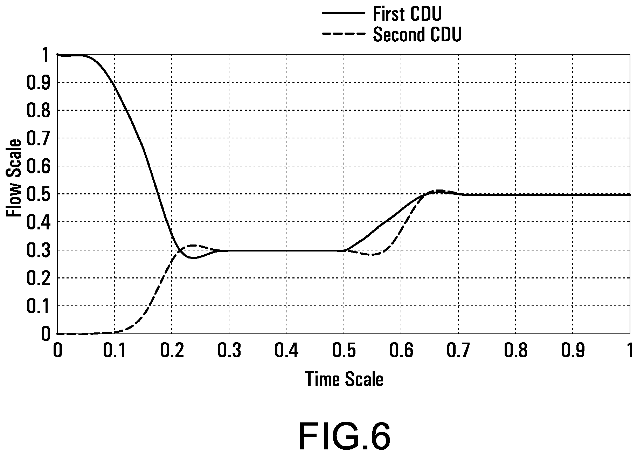

Fig. 6 is an embodiment of a waveform diagram of a flow control for the cooling distribution unit of the disclosure. As shown in Fig. 6, when the second CDU 82 starts to operate from the resting state, the CDU control unit of any CDU of the group makes the first CDU 81 and the second CDU 82 operate at the same second rotation speed by sending the low rotation-speed command. After receiving the low rotation-speed command, the first CDU 81 decreases the rotation speed (e.g., the output flow is gradually decreased) and the second CDU 82 increases the rotation speed (e.g., the output flow is gradually increased). When the first CDU 81 and the second CDU 82 stably operate at the same second rotation speed, the output flow of the first CDU 81 and the second CDU 82 will be the same or extremely close. In the embodiment of Fig. 6, when both the first CDU 81 and the second CDU 82 operate stably at the second rotation speed, the output flow will be close to 0.3 (it is a ratio, i.e., 30% of the demand flow of the control system). When the CDU control unit detects that both the first CDU 81 and the second CDU 82 stably operate at the second rotation speed, the CDU control unit begins to record the time length that the first CDU 81 and the second CDU 82 stably operate. In the embodiment of Fig. 6, when the first CDU 81 and the second CDU 82 stably operate (i.e., the output flow remains 30% of the demand flow) for 4 seconds (Fig. 6 shows an example of the ratio 0.4), the CDU control unit determines that both the first CDU 81 and the second CDU 82 stably operate at the second rotation speed for the preset time length. At this time, the CDU control unit sends the target flow command to the first CDU 81 and the second CDU 82.

One objective of the disclosure is to control the multiple CDUs to perform the heat dissipation for the server rack 9, so the control system has to ensure the total output flow of all the CDUs is capable of satisfying the heat dissipation for the server rack 9. That is, the total output flow of all the CDUs has to be equal to or extremely close to the demand flow preset by the user. Furthermore, the purpose of configuring the multiple CDUs in the control system is not only to configure the redundant CDUs but also to balance the output flow of the CDUs to make the control system stably operate. Therefore, in one embodiment, the CDU control unit of any CDU of the group makes the first CDU 81 and the second CDU 82 output the same target flow by sending the target flow command in step S54, and the sum of the target flow of the first CDU 81 and the target flow of the second CDU 82 has to be equal to or extremely close to the demand flow of the control system. In the embodiment of Fig. 6, the control system includes two CDUs. When the first CDU 81 and the second CDU 82 receive the target flow command and operate according to the target flow command, the output flows of the first CDU 81 and the second CDU 82 are respectively 0.5 (it is a ratio, i.e., 50% of the demand flow of the control system), so the sum of the output flow of the first CDU 81 and the output flow of the second CDU 82 is equal to the demand flow of the control system.

For another example, if the control system includes five CDUs, the CDU control unit of any CDU of the group makes the five CDUs output the same target flow by the target flow command in step S54, and the sum of the target flows of the five CDUs is equal to or extremely close to the demand flow of the control system. That is, the target flow outputted by each CDU is about 20% of the demand flow of the control system. In other words, the target flow of each CDU is the same, and

$$the\ target\ flow = \frac{the\ demand\ flow}{the\ quantity\ of\ the\ CDUs}.$$

It should be noted that the objective of step S52 in Fig. 5 is to decrease the rotation speed of the CDUs in operation to make the CDU at the resting state work smoothly, so the CDU control unit sends the rotation command for directly assigning the rotation speed to the pump group. On the other hand, the objective of step S54 is to make the control system provide the demand flow for the heat dissipation, so the CDU control unit sends the target flow command for directly assigning the target flow to each CDU to ensure each CDU is capable of outputting the cooling liquid of the target flow, such that the cooling liquid outputted by the entire control system meets the requirement of the heat dissipation.

It should be noted that the multiple CDUs of the control system are disposed in parallel, so the impedance encountered by the lines of each CDU may be different. When the multiple CDUs stably output the target flow of the cooling liquid based on the target flow command, the rotation speed of the pump group of each CDU may be different. Specifically, for the CDU having lines with higher impedance, the pump group has to operate at a higher rotation speed to achieve the same target flow. On the contrary, for the CDU having lines with lower impedance, the pump group has to operate at a lower rotation speed to achieve the same target flow. Therefore, to ensure all the CDUs of the CDU group of the control system can stably output the cooling liquid of the demand flow, the CDU control unit will generate and send the target flow command, rather than the command of the rotation speed of each CDU.

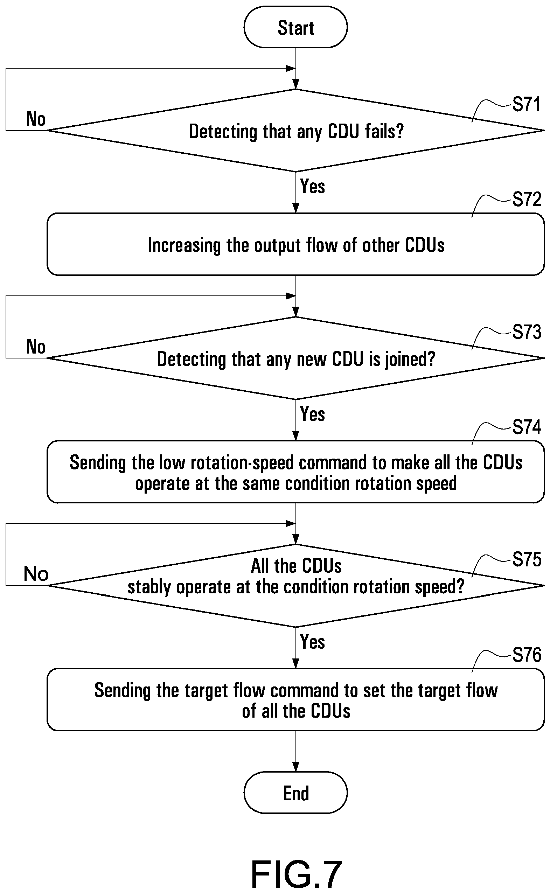

Fig. 7 is another embodiment of a flowchart of the control method of the disclosure. Fig. 7 provides another embodiment of the control method of the disclosure, and the control method is also applied to the control system shown in Fig. 4.

Specifically, after the control system operates, the CDU control unit of any CDU of the group is set to continuously detect among the multiple CDUs whether any CDU fails (step S71). When detecting any CDU (such as the second CDU 82 of Fig. 4) fails, the CDU control unit generates and sends the flow command to other CDUs (such as the first CDU 81 of Fig. 4). Specifically, the CDU control unit makes the total output flow of the control system remain the demand flow required for the heat dissipation by increasing the output flow of the first CDU 81 (step S72).

After step S72, the control system provides the heat dissipation function through the first CDU 81, and the CDU control unit continuously detects whether any new CDU is joined (step S73). The new CDU is the CDU that stays at the resting state and may be activated to share the flow of the first CDU 81. If there is no new CDU is joined, the first CDU 81 of the control system continuously performs the heat dissipation, and the CDU control unit continuously detects any new CDU joined. If the new CDU is joined, to smoothly active the new CDU, the CDU control unit makes the first CDU 81 reduce its rotation speed down to a condition rotation speed by sending the low rotation-speed command, and makes the new CDU operate at the condition rotation speed that is the same with the rotation speed of the first CDU 81 whose rotation speed is reduced (step S74).

Furthermore, the CDU control unit continuously determines whether both the first CDU 81 and the new CDU stably operate at the condition rotation speed (step S75). For example, it is determined that both the first CDU 81 and the new CDU stably output the flow corresponding to the condition rotation speed and the time length of the CDUs remaining stable achieves the preset time length. When determining that both the first CDU 81 and the new CDU stably operate at the condition rotation speed, the CDU control unit then sets the target flow of all the CDUs by sending the target flow command (step S76), such that all the CDUs of the control system outputs the same target flow of the cooling liquid and the sum of the target flow of all the CDUs is equal to or extremely close to the demand flow of the control system.

In the embodiment, the CDU control unit continuously performs step S71 to step S76. Therefore, the control system may continuously output the cooling liquid with the demand flow to meet the requirement of the heat dispassion, provide a CDU backup by increasing the rotation speed of other CDUs if one CDU fails, and adjust the rotation speed and the output flow of all the CDUs when the new CDU is joined, to make the new CDU operate smoothly.

Accordingly, the disclosure provides the technical features of synchronously controlling the rotation speed and the output flow of all the CDUs based on the state (of malfunctions, of recovering from the malfunctions, or of being joined recently) of one CDU to prevent or solve the problem of unstable operations of the CDU group while any CDU fails or any new CDU is joined.

## Claims

1. A control system for cooling distribution units (CDUs), comprising:

   a first CDU (81) configured to operate at a first rotation speed; and
   a second CDU (82) configured to be at a resting state, wherein the first CDU (81) and the second CDU (82) are configured to be a group;
   wherein any CDU of the group is configured to send a low rotation-speed command to the first CDU (81) and the second CDU (82) to indicate the first CDU (81) and the second CDU (82) to operate at a second rotation speed, wherein the second rotation speed is slower than the first rotation speed;
   wherein any CDU of the group is configured to send a target flow command to the first CDU (81) and the second CDU (82) when both the first CDU (81) and the second CDU (82) operate at the second rotation speed for a preset time length, to respectively indicate the first CDU and the second CDU (82) to output a target flow.

2. The control system of claim 1, wherein the first CDU (81) is connected to a first reverse valve, the second CDU (82) is connected to a second reverse valve, and the second rotation speed is a rotation speed enabling the cooling liquid outputted by the first CDU (81) pass through the first reverse valve and enabling the cooling liquid outputted by the second CDU (82) pass through the second reverse valve without being depressed by a pressure generated by the first CDU (81).

3. The control system of any preceding claim, wherein the first CDU (81) comprises a first pump group, the second CDU (82) comprises a second pump group, and the second rotation speed is 50% to 70% of a duty cycle of the first pump group and the second pump group.

4. The control system of any preceding claim, wherein any CDU of the group is configured to send the target flow command when detecting both the first CDU (81) and the second CDU (82) stably operate at the second rotation speed for 4 seconds.

5. The control system of any preceding claim, wherein a demand flow is set to the control system, and a sum of the target flow of the first CDU (81) and the target flow of the second CDU (82) is equal to the demand flow.

6. The control system of any preceding claim, wherein the second CDU (82) is a new CDU being recently added to the control system or an old CDU of the control system recovered from a malfunction state.

7. A control method for cooling distribution units (CDUs), applied to a CDU control system, wherein the CDU control system comprises a group having a first CDU (81) and a second CDU (82), wherein the first CDU (81) operates at a first rotation speed, and the control method comprises:

   step a) detecting the second CDU (82) being activated from a resting state;
   step b) sending a low rotation-speed command to the first CDU (81) and the second CDU (82) by any CDU of the group to indicate the first CDU (81) and the second CDU (82) to operate at a second rotation speed, wherein the second rotation speed is lower than the first rotation speed; and
   step c) when determining that both the first CDU (81) and the second CDU (82) operate at the second rotation speed for a preset time length, sending a target flow command to the first CDU (81) and the second CDU (82) by any CDU of the group to indicate the first CDU (81) and the second CDU (82) to respectively output a target flow.

8. The control method of claim 7, wherein the first CDU (81) is connected to a first reverse valve, the second CDU (82) is connected to a second reverse valve, and the step b) comprises sending the second rotation speed to enable the cooling liquid outputted by the first CDU (81) pass through the first reverse valve and to enable the cooling liquid outputted by the second CDU (82) pass through the second reverse valve without being depressed by a pressure generated by the first CDU (81).

9. The control method of any of claims 7-8, wherein the first CDU (81) comprises a first pump group, the second CDU (82) comprises a second pump group, and the second rotation speed of the step b) is 50% to 70% of a duty cycle of the first pump group and the second pump group.

10. The control method of any of claims 7-9, wherein the step c) comprises sending the target flow command when detecting that both the first CDU (81) and the second CDU (82) stably operate at the second rotation speed for 4 seconds.

11. The control method of any of claims 7-10, wherein the control system is configured to operate at a demand flow, and the step c) comprises sending the target flow command to make a sum of the target flow of the first CDU (81) and the target flow of the second CDU (82) to be equal to the demand flow.

12. The control method of any of claims 7-11, wherein the step a) comprises detecting a new CDU being recently added to the control system or an old CDU of the control system recovered from a malfunction state.

**Amended claims in accordance with Rule 137(2) EPC.**

1. A control method for cooling distribution units (CDUs), applied to a CDU control system, wherein the CDU control system comprises a group having a first CDU (81) and a second CDU (82), wherein the first CDU (81) operates at a first rotation speed, and the control method comprises:

> step a) detecting the second CDU (82) being activated from a resting state;
> **characterized by**
> step b) sending a low rotation-speed command to the first CDU (81) and the second CDU (82) by any CDU of the group to indicate the first CDU (81) to slow down from the first rotation speed to operate at a second rotation speed and indicate the second CDU (82) to speed up from the resting state to operate at the second rotation speed, wherein the second rotation speed is lower than the first rotation speed; and
> step c) when determining that both the first CDU (81) and the second CDU (82) operate at the second rotation speed for a preset time length, sending a target flow command to the first CDU (81) and the second CDU (82) by any CDU of the group to indicate the first CDU (81) and the second CDU (82) speed up from the second rotation speed to to respectively output a target flow, wherein a rotation speed of the first CDU (81) for outputting the target flow and a rotation speed of the second CDU (82) for outputting the target flow are respectively greater than the second rotation speed.

2. The control method of claim 1, wherein the first CDU (81) is connected to a first reverse valve, the second CDU (82) is connected to a second reverse valve, and the step b) comprises sending the second rotation speed to enable the cooling liquid outputted by the first CDU (81) pass through the first reverse valve and to enable the cooling liquid outputted by the second CDU (82) pass through the second reverse valve without being depressed by a pressure generated by the first CDU (81).

3. The control method of any of claims 1-2, wherein the first CDU (81) comprises a first pump group, the second CDU (82) comprises a second pump group, and the second rotation speed of the step b) is 50% to 70% of a duty cycle of the first pump group and the second pump group.

4. The control method of any of claims 1-3, wherein the step c) comprises sending the target flow command when detecting that both the first CDU (81) and the second CDU (82) stably operate at the second rotation speed for 4 seconds.

5. The control method of any of claims 1-4, wherein the control system is configured to operate at a demand flow, and the step c) comprises sending the target flow command to make a sum of the target flow of the first CDU (81) and the target flow of the second CDU (82) to be equal to the demand flow.

6. The control method of any of claims 1-5, wherein the step a) comprises detecting a new CDU being recently added to the control system or an old CDU of the control system recovered from a malfunction state.

FIG.1

FIG.2

FIG.3

FIG.4

Start

S51

Detecting that a CDU starts to operate from a resting state

S52

Sending a low rotation-speed command to all the CDUs

No ← All the CDUs operate stably at a second rotation speed for a preset time length? S53

Yes

S54

Sending a target flow command to all the CDUs to indicate all the CDUs to output the target flow of the cooling liquid

End

FIG.5

FIG.6

Start

S71
Detecting that any CDU fails?

No

Yes

S72
Increasing the output flow of other CDUs

No

S73
Detecting that any new CDU is joined?

Yes

S74
Sending the low rotation-speed command to make all the CDUs operate at the same condition rotation speed

No

S75
All the CDUs stably operate at the condition rotation speed?

Yes

S76
Sending the target flow command to set the target flow of all the CDUs

End

FIG.7

## EUROPEAN SEARCH REPORT

Europäisches
Patentamt
European
Patent Office
Office européen
des brevets

**Application Number**

**EP 25 15 7758**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | CN 116 449 928 A (SHENZHEN YIWANKE DATA EQUIPMENT TECH CO LTD) 18 July 2023 (2023-07-18) * paragraphs [0038] - [0054]; figures 1,2 * ----- | 1-12 | INV. F04D15/00 G06F1/20 H05K7/20 |
| Y | CN 116 744 633 A (WUHAN FIBERHOME TECH SERVICE CO LTD ET AL.) 12 September 2023 (2023-09-12) * paragraphs [0038] - [0072]; figures 1-3 * ----- | 1-12 | |
| A | US 2022/338389 A1 (ZUO WEIDONG [US] ET AL) 20 October 2022 (2022-10-20) * paragraphs [0026] - [0050]; figure 2 * ----- | 2,8 | |

| | |
|---|---|
| | TECHNICAL FIELDS SEARCHED (IPC) |
| | F04D H05K G06F |

The present search report has been drawn up for all claims

| Place of search | Date of completion of the search | Examiner |
|---|---|---|
| The Hague | 23 July 2025 | Nobre Correia, S |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................

& : member of the same patent family, corresponding
    document

EPO FORM 1503 03.82 (P04C01)

2

## ANNEX TO THE EUROPEAN SEARCH REPORT
## ON EUROPEAN PATENT APPLICATION NO.

EP 25 15 7758

This annex lists the patent family members relating to the patent documents cited in the above-mentioned European search report.
The members are as contained in the European Patent Office EDP file on
The European Patent Office is in no way liable for these particulars which are merely given for the purpose of information.

23-07-2025

| Patent document cited in search report | | Publication date | Patent family member(s) | Publication date |
|---|---|---|---|---|
| CN 116449928 | A | 18-07-2023 | NONE | |
| CN 116744633 | A | 12-09-2023 | NONE | |
| US 2022338389 | A1 | 20-10-2022 | NONE | |

EPO FORM P0459

For more details about this annex : see Official Journal of the European Patent Office, No. 12/82